# EUROPEAN PATENT APPLICATION

(11) **EP 4 661 639 A1**
(43) Date of publication of application: **10.12.2025**
(21) Application number: 23925888.2
(22) Date of filing: 02.06.2023
(51) Int. Cl.: H10K 59/122, H10K 50/84, H10K 71/00

(54) **DISPLAY PANEL AND DISPLAY PANEL MANUFACTURING METHOD**

(30) Priority: 03.03.2023 CN 202310197089
(71) Applicant: HKC CORPORATION LIMITED, Shenzhen, Guangdong 518000 (CN)
(72) Inventor: JIANG, Lei, Shenzhen, Guangdong 518000 (CN); ZHOU, Yangchuan, Shenzhen, Guangdong 518000 (CN); LI, Rongrong, Shenzhen, Guangdong 518000 (CN)
(74) Representative: dompatent
(86) International application number: PCT/CN2023/098102
(87) International publication number: WO 2024/183175

(57) **Abstract**

The present application provides a display panel and a method for fabricating the display panel, which relate to the technical field of display. The display panel includes, from bottom to top: a substrate (10), a drive layer (20), an anode layer (30), a luminescent layer (40), a cathode layer (50), and an encapsulation layer (60). The anode layer (30) includes a plurality of anode units arranged at intervals. A pixel defining layer is arranged around the plurality of anode units. The pixel defining layer includes a plurality of pixel defining units (70), each of the plurality of pixel defining units (70) is arranged between adjacent anode units. A plurality of conductive units (80) are arranged on the plurality of pixel defining unit (70), respectively, and a plurality of eave layers (90) are arranged on the plurality of conductive units (80), respectively. The luminescent layer (40) is covered on the plurality of anode units and the plurality of pixel defining units (70). The cathode layer (50) is covered on the luminescent layer (40). The encapsulation layer (60) is covered on the cathode layer (50), the plurality of conductive units (80), and the plurality of eave layers (90). A lateral side of each of the plurality of pixel defining units (70) is a downwardly concave slope. The technical solution provided by the present application can reduce the formation of voids in the region below of the eave layer during the fabrication of the OLED by photolithography.

## Description

This application claims the priority of the Chinese patent application submitted to the CNIPA on Mar. 3, 2023, with an application number 202310197089.4 and titled "DISPLAY PANEL AND METHOD FOR FABRICATING THE SAME", the entire contents of which are incorporated by reference in this application.

### TECHNICAL FIELD

The present application relates to the technical field of display, and more particularly to a display panel and a method for fabricating the same.

### BACKGROUND

Light emitting devices, such as organic light emitting diodes (OLED), are more and more widely used in products including computers and mobile phones, due to the characteristics of thinness and light weight, energy saving, wide color gamut, and high contrast.

When fabricating the OLED, more and more manufacturers have begun to use photolithography to etch the entire substrate after film formation to form the OLED.

However, when photolithography is used to prepare the OLED, it is easy to form voids in the area below the side of the eave layer. Since the stress at the position of the voids cannot be relieved, cracks will appear at the position of the voids during the subsequent fabricating process and panel transfer, allowing water vapor to intrude Display defects such as dark dots, black dots, etc. appear. Voids are easily formed in regions below the eave layer, since the stresses in the regions of the voids are unable to be relieved, and cracks easily occur in the subsequent fabricating process, the panel transfer process, and in use, resulting in water vapor intrusion and display defects such as dark spots and black spots.

It is one of objectives of the present application to provide a display panel and a method for fabricating the same, so as to reduce the occurrence of voids in the region below the eave layer during the fabrication of the OLED by photolithography.

### TECHNICAL SOLUTIONS

In a first aspect, embodiments of the present application provide a display panel. The display panel comprises, from bottom to top: a substrate, a drive layer, an anode layer, a luminescent layer, a cathode layer, and an encapsulation layer.

The anode layer comprises a plurality of anode units arranged at intervals. A pixel defining layer is arranged around the plurality of anode units. The pixel defining layer comprises a plurality of pixel defining units, each of the plurality of pixel defining units is arranged between adjacent anode units. A plurality of conductive units are arranged on the plurality of pixel defining units, respectively, and a plurality of eave layers are arranged on the plurality of conductive units, respectively.

The luminescent layer is covered on the plurality of anode units and the plurality of pixel defining units. The cathode layer is covered on the luminescent layer. The encapsulation layer is covered on the cathode layer, the plurality of conductive units, and the plurality of eave layers.

A lateral side of each of the plurality of pixel defining units is a downwardly concave slope.

As an optional implementation of the embodiment of the present application, a projection area of a lower end surface of each of the plurality of conductive units onto the substrate is within a projection area of an upper end surface of a corresponding pixel defining unit onto the substrate.

As an optional implementation of the embodiment of the present application, a maximum distance between an edge of the upper end surface of each of the plurality of pixel defining units and an edge of the lower end surface of a corresponding conductive unit is smaller than or equal to 1 µm.

As an optional implementation manner of an embodiment of the present application, the lateral side of each of the plurality of pixel defining units is a downwardly concave curved surface.

As an optional implementation manner of an embodiment of the present application, the lateral side of each of the plurality of pixel defining units is in a stepped structure.

As an optional implementation of the embodiment of the present application, the lateral side of each of the plurality of pixel defining units comprises a plurality of steps.

As an optional implementation manner of an embodiment of the present application, a chamfer is provided between an edge of an upper end surface of each of the plurality of pixel defining units and the lateral side of each of the plurality of pixel defining units.

As an optional implementation of the embodiment of the present application, a distance between an edge of a lower end surface of each of the plurality of conductive units and an edge of a lower end surface of a corresponding eave layer is greater than or equal to 2 µm and smaller than or equal to 3 µm.

As an optional implementation of the embodiment of the present application, an included angle between an upper end surface of the anode layer and a connection line between two end points of a longitudinal section of the lateral side of each of the plurality of pixel defining units is greater than or equal to 15 degrees, and smaller than or equal to 45 degrees.

As an optional implementation of the embodiment of the present application, each of the plurality of pixel defining units partially covers corresponding anode units.

As an optional implementation of the embodiment of the present application, a width of the each of the plurality of insulation columns covering a corresponding anode unit is greater than or equal to 0.5 µm and smaller than or equal to 1 µm.

As an optional implementation of the embodiment of the present application, a thickness of each of the insulation columns covering a corresponding anode unit is greater than or equal to 0.3 µm and smaller than or equal to 2 µm.

As an optional implementation of the embodiment of the present application, the encapsulation layer comprises: a first inorganic encapsulation layer, an organic buffer layer, and a second inorganic encapsulation layer arranged from bottom to top.

As an optional implementation of the embodiment of the present application, a material of the first inorganic encapsulation layer is the same as a material of the second inorganic encapsulation layer.

In a second aspect, embodiments of the present application provide a method for fabricating a display panel, which is used to form the display panel according to the first aspect or any embodiment of the first aspect. The method includes:
forming the drive layer on the substrate,
forming the anode layer on the drive layer, in which, the anode layer comprises the plurality of anode units arranged at intervals;
forming each of the plurality of pixel defining units between adjacent anode units;
forming the luminescent layer above the anode layer and the plurality of pixel defining units, and forming the cathode layer on the luminescent layer;
forming the plurality of conductive units on the plurality of pixel defining units, respectively, and forming the plurality of eave layers on the plurality of conductive units, respectively; and
forming the encapsulation layer above the cathode layer, the plurality of conductive units, and the plurality of eave layers.

### BENEFICIAL EFFECTS

In the display panel and the method for fabricating the display panel provided in embodiments of the present application, the substrate, the drive layer, the anode layer, the luminescent layer, the cathode layer, and the encapsulation layer are arranged from bottom to top. The anode layer comprises the plurality of anode units arranged at intervals. the pixel defining layer is arranged around the plurality of anode units. The pixel defining layer comprises the plurality of pixel defining units, each of the plurality of pixel defining units is arranged between adjacent anode units. The plurality of conductive units are arranged on the plurality of pixel defining units, respectively, and the plurality of eave layers are arranged on the plurality of conductive units, respectively. The luminescent layer is covered on the plurality of anode units and the plurality of pixel defining units. The cathode layer is covered on the luminescent layer. The encapsulation layer is covered on the cathode layer, the plurality of conductive units, and the plurality of eave layers. The lateral side of each of the plurality of pixel defining units is the downwardly concave slope. In this way, an end protrusion of the upper end surface of the pixel defining unit can be lowered, so that the OLED is fabricated by photolithography, a stacking height of the encapsulation layer on the upper end surface of the pixel defining unit can be lowered, and the situation that the encapsulation layer on the upper end surface of the pixel defining unit is connected with the encapsulation layer on the lower end surface of the eave layer can be reduced, and the formation of voids in the region below the eave layer can be reduced, thereby reducing the occurrence of display defects on the display panel.

### BRIEF DESCRIPTION OF THE DRAWINGS

In order to more clearly illustrate the technical solutions in the embodiments of the present application, the accompanying drawings required for use in the description of the embodiments will be briefly introduced below. Obviously, the accompanying drawings in the following description are only some embodiments of the present application. For those of ordinary skill in the art, other drawings can be obtained from these drawings without creative effort.
FIG. **1** is a schematic structural diagram of a display panel in an exemplary technology;
FIG. **2** is a schematic structural diagram of a display panel provided by an embodiment of the present application;
FIG. **3** is a schematic structural diagram of a display panel provided by another embodiment of the present application;
FIG. **4** is a partial schematic structural diagram of the display panel in FIG. **2****;** and

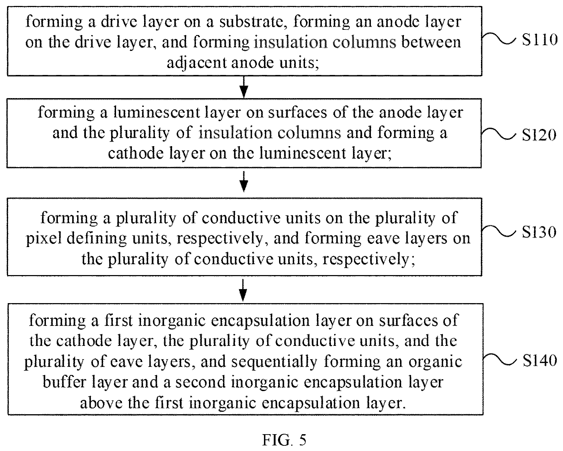

FIG. **5** is a schematic flowchart of a method for fabricating a display panel provided in an embodiment of the present application.

In the drawings, the following reference numerals are adopted:
**10:** Substrate; **20:** Drive layer; **30:** Anode layer; **40:** Luminescent layer; **50:** Cathode layer; **60:** Encapsulation layer; **70:** Pixel defining unit; **80:** Conductive unit; **90:** Eave layer; **99:** Void; **61:** First inorganic encapsulation layer; **62:** Organic buffer layer; and **63:** Second inorganic encapsulation layer.

### DETAILED DESCRIPTION OF THE EMBODIMENTS

In order to make the purpose, technical solutions, and advantages of the present application clearer, the following embodiments of the present application will be further described in detail in conjunction with the accompanying drawings in the embodiments of the present application.

Embodiments of the present application are described below with reference to the drawings in the embodiments of the present application. Terms used in the implementation of the embodiments of the present application are only used to explain the specific embodiments of the present application, and are not intended to limit the present application. The following specific embodiments may be combined with each other, and the same or similar concepts or processes may not be repeated in some embodiments.

A light emitting device in embodiments of the present application may be any one of an organic light emitting diode (OLED), an inorganic light emitting diode (LED), a quantum dot light emitting diode (QLED), and a mini light emitting diode (Mini LED). In this embodiment, it is taken the light emitting device being the OLED as an example for exemplary description.

At present, there are usually three methods to make a light emitting device in a display panel: a first method is to use a fine metal mask as a mask to deposit light emitting devices of different colors, a second method is to use inkjet printing to print light emitting devices of different colors, and a third method is uses photolithography to etch the entire substrate after film formation to produce light emitting devices of different colors. With the increase of the pixel density of the display panel, it has become a subject of in-depth research in the industry to use photolithography to etch patterns.

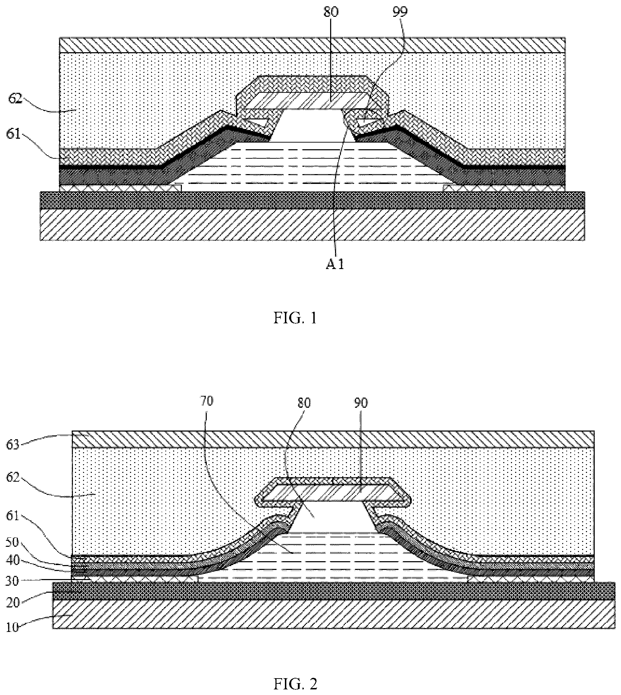

FIG. **1** is a schematic structural diagram of a display panel in an exemplary technology. As shown in FIG. **1****,** due to the limitation of an end of the eave layer **90,** a thickness of all the film layers in region A**1** is lower than that of an end edge of the eave layer **90** as well as that of a film layer of a portion away from the end, such that different portions of the first inorganic encapsulation layer **61** are prone to be connected at the lower end of the ever layer **90,** and a void is therefore formed in the region A**1** below the eave layer **90,** which makes the material of the organic buffer layer **62** unable to fill the void **99** and the stress in the region A**1** unable to be relieved, and cracks easily occur in the subsequent fabricating process, the panel transfer process, and in use, resulting in water vapor intrusion and display defects such as dark spots and black spots.

In view of this, embodiments of the present application provide a display panel, which is used to reduce the formation of voids in the region below the eave layer **90** when the light emitting device is fabricated using photolithography technology, thereby reducing the occurrence of display defects on the display panel.

FIG. **2** is a schematic structural diagram of a display panel provided by an embodiment of the present application. As shown in FIG. **2****,** the display panel provided by this embodiment may include, from bottom to top: a substrate **10,** a drive layer **20,** an anode layer **30,** a luminescent layer **40,** a cathode layer **50,** and an encapsulation layer **60.**

The substrate **10** can be a rigid substrate or a flexible substrate. The rigid substrate can be made of glass, and the flexible substrate can be made of a polymer material, such as a polyimide.

The drive layer **20** is located above the substrate **10** and may include a plurality of thin film transistors (TFT) for driving the luminescent layer **40** to emit light.

The anode layer **30** is located above the drive layer **20,** and the material of the anode layer **30** can be conductive metal oxide, such as indium tin oxide (ITO) and the like.

The anode layer **30** may include a plurality of anode units arranged at intervals, the pixel defining layer is arranged around the plurality of anode units, the pixel defining layer includes a plurality of pixel defining units **70,** and each of the plurality of pixel defining units **70** are arranged between adjacent anode units. The pixel defining unit can be made of an organic polyimide, or inorganic SiNₓ, SiOₓ, SiOₓNₓ, or the like

A lateral side of each pixel defining unit **70** can be a downwardly concave slope, which can lower an end protrusion of the upper end surface of the pixel defining unit **70,** so that when the OLED is fabricated by photolithography, a stacking height of the encapsulation layer on the upper end surface of the pixel defining unit **70** can be lowered, and the situation that the encapsulation layer on the upper end surface of the pixel defining unit **70** is connected with the encapsulation layer on the lower end surface of the eave layer **90** can be reduced, and the formation of voids in the region below the eave layer **90** can be reduced, thereby reducing the occurrence of display defects on the display panel.

Specifically, the lateral side of each pixel defining unit **70** can be a downwardly concave curved surface, so that the lateral side of the pixel defining unit **70** can be connected with the upper end surface of the drive layer **20** more smoothly, and the occurrence of cracks at the connection between the lateral side of the pixel defining unit **70** and the upper end surface of the drive layer **20** caused by external force can be reduced, thereby enhancing the folding and bending ability of the display panel.

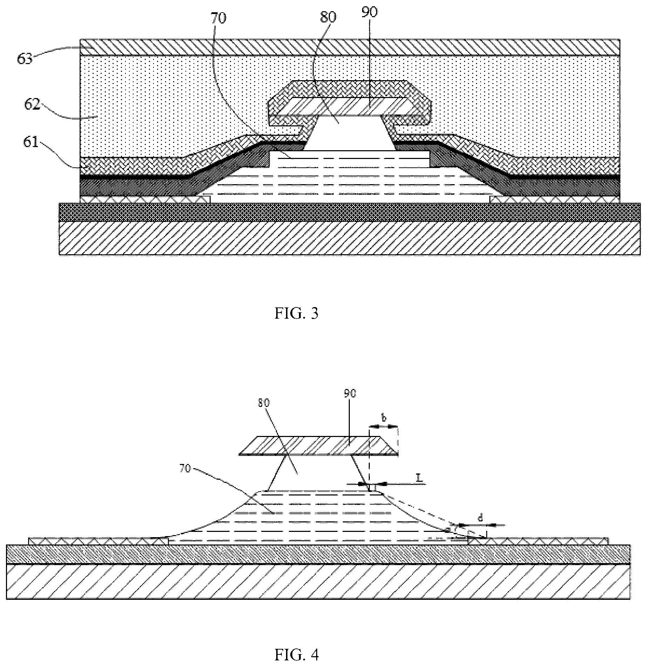

FIG. **3** is a schematic structural diagram of a display panel provided by another embodiment of the present application. As shown in FIG. **3****,** a top of the lateral side of the pixel defining unit **70** may be in a stepped structure. In this way, not only can the stacking height of the encapsulation layer on the pixel defining unit **70** be lowered and can the situation that the encapsulation layer on the upper end surface of the pixel defining unit **70** is connected with the p encapsulation layer on the lower end surface of the eave layer **90** be reduced, but also the area of the lateral side of the pixel defining unit **70** can increase. Therefore, during the fabrication process of the display panel, the luminescent layer **40** and the cathode layer **50** can have a larger adhesion area, thereby achieving a better adhesion effect and improving a yield rate of the display panel.

It can be understood that the number of steps on the lateral side of the pixel defining unit **70** may be more than that shown in FIG. **3****,** which is not specifically limited in the present application.

A conductive unit **80** is arranged on each pixel defining unit **70,** and the conductive unit **80** can be made of copper, silver, and other metals. An eave layer **90** is arranged on each conductive unit **80,** and the eave layer **90** is configured to disconnect the cathode layer **50** from the encapsulation layer **60** on the eave layer **90,** so that the encapsulation layer **60** can well protect the cathode layer **50** and prevent the cathode layer **50** from being affected by the etching solution in subsequent pattern lithography process.

A chamfer may also be provided between an edge of the upper end surface of each pixel defining unit **70** and the lateral side of each pixel defining unit **70,** so as to further reduce the end protrusion of the upper end surface of the pixel defining unit **70.**

The luminescent layer **40** covers the anode units and the pixel defining units **70,** and the luminescent layer **40** may luminescent materials for emitting various color lights such as red light, green light, and blue light.

The cathode layer **50** is covered on the luminescent layer **40,** and the cathode layer **50** can be made of a metal material, such as aluminum (Al), gold (Au), silver (Ag), a magnesium (Mg)-Ag alloy, and the like.

The encapsulation layer **60** covers the cathode layer **50,** the conductive units **80,** and the eave layers **90.** The encapsulation layer **60** may include a first inorganic encapsulation layer **61,** an organic buffer layer **62,** and a second inorganic encapsulation layer **63.**

The first inorganic encapsulation layer **61** is disposed above the cathode layer **50** and the eave layers **90,** and the first inorganic encapsulation layer **90** may be made of a material including silicon nitride, silicon oxynitride, or a combination thereof.

The organic buffer layer **62** is disposed above the first inorganic encapsulation layer **61,** and the organic buffer layer **100** is made of a transparent photoresist having a high refractive index, such as a polyimide photosensitive polymer and other materials.

The second inorganic encapsulation layer **63** is disposed above the organic buffer layer **62,** and a material of the second inorganic encapsulation layer **63** is the same as that of the first inorganic encapsulation layer **61.**

FIG. **4** is a partial schematic structural diagram of the display panel in FIG. **2****.** As shown in FIG. **4****,** a projection area of a lower end surface of the conductive unit **80** onto the substrate **10** is within a projection area of an upper end surface of a corresponding pixel defining unit **70** onto the substrate. The upper end surface of the pixel defining unit **70** can be constructed to be relatively small, for example, a maximum distance L between an edge of the upper end surface of the pixel defining unit **70** and an edge of a lower end surface of a corresponding conductive unit **80** can be smaller than or equal to 1 µm. In this way, a width of the cathode layer **50** covering the upper end surface of the pixel defining unit **70** can be shortened, thereby shortening the coverage width of the encapsulation layer **60** on the upper end surface of the pixel defining unit **70,** and in turn reducing the occurrence of connection between the encapsulation layer on the upper end surface of the pixel defining unit **70** and the encapsulation layer on the lower end surface of the eave layer **90.**

A distance b between an edge of a lower end surface of each of the plurality of conductive units **80** and an edge of a lower end surface of a corresponding eave layer **90** may be greater than or equal to 2 µm and smaller than or equal to 3 µm. In this way, the lower end surface of each eave layer **90** cannot be too large, the width of the capsulation layer at the lower end surface of the eave layer **90** is therefore shortened, which further reduces the occurrence of connection between the encapsulation layer on the upper end surface of the pixel defining unit **70** and the encapsulation layer on the lower end surface of the eave layer **90.** Moreover, the shading effect of the eave layer **90** can be ensured.

An included angle ø between an upper end surface of the anode layer **30** and a connection line between two end points of a longitudinal section of a lateral side of each pixel defining unit **70** can be greater than or equal to 15 degrees, and smaller than or equal to 45 degrees. In this way, on the premise of satisfying the requirement for the inclination of the lateral side of the pixel defining unit **70** in the fabricating process, the lateral side of the pixel defining unit **70** will not be too steep, thereby reducing the occurrence of cracking at the lateral side of the pixel defining unit **70** due to external force, and enhancing folding and bending ability of the display panel.

Each pixel defining unit **70** can also partially cover corresponding anode units to control an area of each anode unit, so that the area of each anode unit approaches the same, which makes the light emitting area of the pixel unit corresponding to each anode unit approach the same, thereby improving display effect.

A width d of each pixel defining unit **70** covering on corresponding anode units can be greater than or equal to 0.5 µm and smaller than or equal to 1 µm, so that on the premise that the area of each anode unit is not occupied too much and a luminous area of each pixel unit is sufficient, the area of each anode unit is controlled, making the light emitting areas of the pixel units corresponding to each anode unit tend to be the same.

A thickness of each pixel defining u104nit **70** covering corresponding anode units may be greater than or equal to 0.3 µm and smaller than or equal to 2 µm. In this way, the covering thickness of the pixel defining unit **70** can be reduced on the premise of ensuring the covering effect, so that the anode unit and the corresponding luminescent layer **40** can be more closely fitted.

FIG. **4** is a schematic flowchart of a method for fabricating a display panel provided in an embodiment of the present application. As shown in FIG. **4****,** the method may be formed by the following steps:

In step **S110,** a drive layer is formed on a substrate, an anode layer is formed on the drive layer, and pixel defining units are formed between adjacent anode units.

Specifically, the anode layer **30** may be basically formed on the substrate by a sputtering process, and the anode layer **30** may include a plurality of anode units arranged at intervals, and then a plurality of pixel defining units **70** may be formed among the plurality of anode units.

In step **S120,** a luminescent layer is formed on surfaces of the anode layer and the plurality of pixel defining units, and a cathode layer is formed on the luminescent layer.

Specifically, the luminescent layer **40** and the cathode layer **50** can be sequentially formed on the surfaces of the anode layer **30** and the plurality of pixel defining units **70** by using an evaporation process.

In step **S130,** a plurality of conductive units are formed on the plurality of pixel defining units, respectively, and eave layers are formed on the plurality of conductive units, respectively.

In step **S140,** a first inorganic encapsulation layer is formed on surfaces of the cathode layer, the plurality of conductive units, and the plurality of eave layers, and an organic buffer layer and a second inorganic encapsulation layer are sequentially formed above the first inorganic encapsulation layer.

Specifically, the first inorganic encapsulation layer **61** can be formed on surfaces of the conductive units **80** and the eave layers **90** by using processes such as plasma enhanced chemical vapor deposition, sputtering, and atomic layer deposition, and the organic buffer layer **62** can be formed on the first inorganic encapsulation layer **61** by using an inkjet printing method, after that, a second inorganic encapsulation layer **63** can be formed on the organic buffer layer **62** by using processes such as plasma enhanced chemical vapor deposition, sputtering, and atomic layer deposition.

In the display panel and the method for fabricating the display panel provided in embodiments of the present application, the substrate, the drive layer, the anode layer, the luminescent layer, the cathode layer, and the encapsulation layer are arranged from bottom to top. The anode layer comprises the plurality of anode units arranged at intervals. The pixel defining layer is arranged around the plurality of anode units. The pixel defining layer comprises the plurality of pixel defining units, each of the plurality of pixel defining units is arranged between adjacent anode units. The plurality of conductive units are arranged on the plurality of pixel defining units, respectively, and the plurality of eave layers are arranged on the plurality of conductive units, respectively. The luminescent layer is covered on the plurality of anode units and the plurality of pixel defining units. The cathode layer is covered on the luminescent layer. The encapsulation layer is covered on the cathode layer, the plurality of conductive units, and the plurality of eave layers. The lateral side of each of the plurality of pixel defining units is the downwardly concave slope. In this way, an end protrusion of the upper end surface of the pixel defining unit can be lowered, so that the OLED is fabricated by photolithography, a stacking height of the encapsulation layer on the upper end surface of the pixel defining unit can be lowered, and the situation that the encapsulation layer on the upper end surface of the pixel defining unit is connected with the encapsulation layer on the lower end surface of the eave layer can be reduced, and the formation of voids in the region below the eave layer can be reduced, thereby reducing the occurrence of display defects on the display panel.

In the above-mentioned embodiments, the descriptions of the embodiments have their own emphases, and for parts that are not detailed or recorded in a certain embodiment, relevant descriptions of other embodiments can be referred to.

In addition, the size ratio relationship among the various components in the drawings is only schematic, which does not reflect the actual size ratio relationship between the various components.

In the description of the present application, orientations or positional relationships indicated by the terms "central", "longitudinal", "transverse", "upper", "lower", "front", "rear", "left", "right", "vertical" "horizontal", "top", "bottom", "inner", "outer", and the like are based on the orientations or positional relationships shown in the drawings, and are only for the convenience of describing the present application and simplifying the description, rather than indicating or implying that a referenced device or element must have a particular orientation, or be constructed and operated in a particular orientation, and should therefore not be construed as limiting the present application.

In the description of the present application, it should be noted that unless otherwise specified and limited, the terms "installation" and "connection" should be understood in a broad sense, for example, it can be a fixed connection or a detachable connection, or an integral connection; it can be mechanically connected or electrically connected; it can be directly connected or indirectly connected through an intermediary, and it can be the internal communication of two components. Those skills in the art can understand the specific meanings of the above terms in the present application based on specific situations.

It should be understood that when used in this specification and the appended claims, the term "comprising" indicates the presence of described features, integers, steps, operations, elements, and/or components, but does not exclude existence or addition of one or more other features, wholes, steps, operations, elements, components and/or collections thereof.

In the description of the present application, unless otherwise specified, "/" means that the objects associated with each other are an "or" relationship, for example, A/B can mean A or B; "and/or" in the present application is only an association relationship describing associated objects, which means that there can be three kinds of relationships, for example, A and/or B, which can mean: A exists alone, A and B exist at the same time, and B exists alone, in which, A and B can be singular or plural.

In the description of the present application, unless otherwise specified, "plurality" means two or more than two. "At least one of the following" or similar expressions refer to any combination of these items, including any combination of single items or plural items. For example, at least one of a, b, or c can represent: a, b, c, a-b, a-c, b-c, or a-b-c, in which, a, b, c can be singular or plural.

In addition, in the description of the specification and the appended claims of the present application, the terms "first", "second", "third", and the like are used to distinguish similar objects, and not necessarily used to describe a specific order or sequence order. It is to be understood that the terms so used are interchangeable under appropriate circumstances such that the embodiments described herein can be practiced in sequences other than those illustrated or described herein.

Reference to "an embodiment" or "some embodiments" or the like in the specification of the present application means that a particular feature, structure, or characteristic described in connection with such embodiment is included in one or more embodiments of the present application. Thus, appearances of the phrases "in an embodiment", "in some embodiments", "in other embodiments", "in still other embodiments", and the like in various places in this specification are not necessarily all refer to the same embodiment, but mean "one or more but not all embodiments", unless specifically stated otherwise.

Finally, it should be noted that: the above embodiments are only used to illustrate the technical solutions of the present application, rather than making limitations on the technical solutions; although the application has been described in detail with reference to the foregoing embodiments, those skills in the art should understand that: it is still possible to modify the technical solutions described in the foregoing embodiments, or perform equivalent replacements for some or all of the technical features; and these modifications or replacements do not make the essence of the corresponding technical solutions deviate from the scope of technical solutions of the various embodiments of the present application.

## Claims

1. A display panel, **characterized by** comprising, from bottom to top: a substrate, a drive layer, an anode layer, a luminescent layer, a cathode layer, and an encapsulation layer;
wherein
the anode layer comprises a plurality of anode units arranged at intervals; a pixel defining layer is arranged around the plurality of anode units; the pixel defining layer comprises a plurality of pixel defining units, each of the plurality of pixel defining units is arranged between adjacent anode units; a plurality of conductive units are arranged on the plurality of pixel defining units, respectively, and a plurality of eave layers are arranged on the plurality of conductive units, respectively;
the luminescent layer is covered on the plurality of anode units and the plurality of pixel defining units; the cathode layer is covered on the luminescent layer; the encapsulation layer is covered on the cathode layer, the plurality of conductive units, and the plurality of eave layers; and
a lateral side of each of the plurality of pixel defining units is a downwardly concave slope.

2. The display panel according to claim 1, wherein a projection area of a lower end surface of each of the plurality of conductive units onto the substrate is within a projection area of an upper end surface of a corresponding pixel defining unit onto the substrate.

3. The display panel according to claim 2, wherein a maximum distance between an edge of the upper end surface of each of the plurality of pixel defining units and an edge of the lower end surface of a corresponding conductive unit is smaller than or equal to 1 µm.

4. The display panel according to claim 1, wherein the lateral side of each of the plurality of pixel defining units is a downwardly concave curved surface.

5. The display panel according to claim 1, wherein the lateral side of each of the plurality of pixel defining units is in a stepped structure.

6. The display panel according to claim 5, wherein the lateral side of each of the plurality of pixel defining units comprises a plurality of steps.

7. The display panel according to claim 1, wherein a chamfer is provided between an edge of an upper end surface of each of the plurality of pixel defining units and the lateral side of each of the plurality of pixel defining units.

8. The display panel according to claim 1, wherein a distance between an edge of a lower end surface of each of the plurality of conductive units and an edge of a lower end surface of a corresponding eave layer is greater than or equal to 2 µm and smaller than or equal to 3 µm.

9. The display panel according to claim 1, wherein an included angle between an upper end surface of the anode layer and a connection line between two end points of a longitudinal section of the lateral side of each of the plurality of pixel defining units is greater than or equal to 15 degrees, and smaller than or equal to 45 degrees.

10. The display panel according to claim 1, wherein each of the plurality of pixel defining units partially covers corresponding anode units.

11. The display panel according to claim 10, wherein a width of the each of the plurality of insulation columns covering a corresponding anode unit is greater than or equal to 0.5 µm and smaller than or equal to 1 µm.

12. The display panel according to claim 10, wherein a thickness of each of the plurality of insulation columns covering a corresponding anode unit is greater than or equal to 0.3 µm and smaller than or equal to 2 µm.

13. The display panel according to any one of claims 1-12, wherein the encapsulation layer comprises: a first inorganic encapsulation layer, an organic buffer layer, and a second inorganic encapsulation layer arranged from bottom to top.

14. The display panel according to claim 13, wherein a material of the first inorganic encapsulation layer is the same as a material of the second inorganic encapsulation layer.

15. A method for fabricating a display panel, **characterized by** being configured to form the display panel according to any one of claims 1-14, wherein the method comprises:
forming the drive layer on the substrate;
forming the anode layer on the drive layer, wherein the anode layer comprises the plurality of anode units arranged at intervals;
forming each of the plurality of pixel defining units between adjacent anode units;
forming the luminescent layer above the anode layer and the plurality of pixel defining units, and forming the cathode layer on the luminescent layer;
forming the plurality of conductive units on the plurality of pixel defining units, respectively, and forming the plurality of eave layers on the plurality of conductive units, respectively; and
forming the encapsulation layer above the cathode layer, the plurality of conductive units, and the plurality of eave layers.
